Europäisches Patentamt

European Patent Office

Office européen des brevets

(11) Veröffentlichungsnummer: **0 258 828**

**A1**

## (12) EUROPÄISCHE PATENTANMELDUNG

(21) Anmeldenummer: 87112506.8

(22) Anmeldetag: 27.08.87

(51) Int. Cl.⁴: **G11C 5/00**

(30) Priorität: 28.08.86 DE 3629267

(43) Veröffentlichungstag der Anmeldung:
09.03.88 Patentblatt 88/10

(84) Benannte Vertragsstaaten:
AT BE CH DE ES FR GB IT LI NL SE

(71) Anmelder: **Siemens Aktiengesellschaft Berlin
und München**
**Wittelsbacherplatz 2**
**D-8000 München 2(DE)**

(72) Erfinder: **Sánchez Aylas, Victor David,
Dipl.-Ing.**
**Gerwigstrasse 49a**
**D-7500 Karlsruhe 1(DE)**

(54) **Stromversorgung für Speicherbausteine.**

(57) Die Erfindung betrifft eine Stromversorgung für Speicherbausteine (beispielsweise CMOS-RAM's), deren Inhalt gespeichert und unverfälscht bleiben soll. Die Speicherbausteine eines elektronischen Systems werden im ausgeschalteten Zustand des Systems durch eine Pufferbatterie versorgt. Zur Erhaltung von Anwenderprogrammen bzw. Daten in der Automatisierungstechnik werden steckbare EPROM- oder RAM-Speichermodule verwendet. Soll eine - schnelle Programmänderbarkeit online, d. h. ohne Prozeßunterbrechung, möglich sein, bei gleichzeitiger Datenerhaltung ohne Systemversorgung, d. h., ohne daß das Speichermodul im System gesteckt bleibt, dann muß eine zusätzliche Batterie auf dem Modul sitzen, deren Spannung außerdem für den Fall überwacht werden soll, daß die Modulbatterie sich entleert und die gespeicherten Daten verlorengehen.

Die Erfindung ist vor allem bei Speichermodulen in speicherprogrammierbaren Steuerungen anwendbar.

FIG 6

**EP 0 258 828 A1**

## Stromversorgung für Speicherbausteine

Die Erfindung bezieht sich auf eine Stromversorgung für Speicherbausteine mit den Merkmalen des Oberbegriffs des Anspruchs 1.

In elektronischen Systemen, die mit statischen CMOS-Speicherbausteinen bestückt sind, werden im ausgeschalteten Zustand des Systems zur Erhaltung von Anwenderprogrammen oder Daten die Speicherbausteine durch eine Pufferbatterie versorgt, die sich im elektronischen System befindet. Sobald ein Speicherbaustein im ausgeschalteten Zustand vom elektronischen System entfernt wird, gehen die gespeicherten Daten nach kurzer Zeit verloren.

Der Erfindung liegt die Aufgabe zugrunde, bei einer Stromversorgung für Speicherbausteine eine sichere, unterbrechungsfreie Stromversorgung bei geringem Platzbedarf zu schaffen.

Zur Lösung der gestellten Aufgabe werden bei einer Stromversorgung der eingangs angegebenen Art die Merkmale des Kennzeichens des Anspruchs 1 angewendet.

Die beschriebenen technischen Probleme werden in vorteilhafter Weise durch die vorliegende Erfindung dadurch gelöst, daß der Speicherbaustein sich im vom elektronischen System abgekoppelten Zustand durch die auf dem Baustein befindliche Modulbatterie versorgt. Das stoßfreie Umschalten zwischen Hauptversorgung, Systembatterie und Modulbatterie, vor allem während des Herausnehmens des Speicherbausteins aus dem elektronischen System sowie während des Steckens in das System, kann hierbei auf einfache Art und Weise gewährleistet werden.

Die Überwachungselektronik auf dem Speicherbaustein liefert hierbei das Erkennungssignal für die Unterschreitung des festgelegten Schwellwertes durch die Batteriespannung der Modulbatterie gemäß Unteranspruch 2 nur, wenn die Hauptversorgung aktiv ist; somit werden beide Batterien von einer überflüssigen Strombelastung verschont.

Die Erfindung wird anhand der Figuren erläutert, wobei

Figur 1 eine herkömmliche Ausführungsform eines Speicherbausteins,

Figur 2 eine herkömmliche Beschaltung von zwei Speicherbausteinen mit Stromversorgung,

Figur 3 ein Ausführungsbeispiel einer Stromversorgung mit Überwachungselektronik,

Figur 4 ein Ausführungsbeispiel einer Umschaltung der Stromversorgung,

Figur 5 ein detailliertes Ausführungsbeispiel einer Überwachungselektronik und

Figur 6 ein Übersichtsschaltbild einer Stromversorgung mit Versorgungsumschaltung und Überwachungselektronik darstellt.

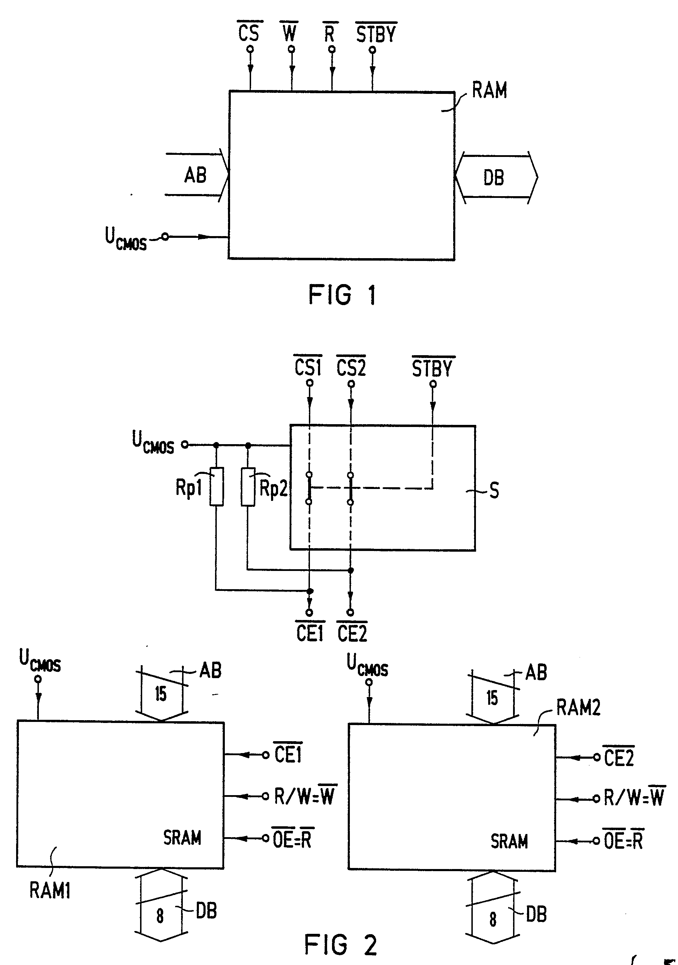

Figur 1 stellt das Blockschaltbild eines herkömmlichen statischen Speicherbausteins RAM ohne eine Batteriepufferung und ohne Batterieüberwachung dar. Ein Signal $\overline{CS}$ ist eine sogenannte "Chip-Select"-Leitung; die Signale $\overline{W}$ und $\overline{R}$ übertragen jeweils das Schreib-und Lesesignal, und das Signal $\overline{STBY}$ überträgt das "Stand by"-Signal, mit dem vom Normalbetrieb in den Pufferbetrieb umgeschaltet wird. Die Spannung $U_{CMOS}$ ist die Versorgungsspannung, die im Normalbetrieb auf die Hauptversorgung und im Pufferbetrieb auf die nicht dargestellte Systembatterie - schaltet. Ferner ist ein Datenbus DB und ein Adreßbus an den Speicherbaustein RAM angeschaltet.

In der Figur 2 ist die nähere Realisierung mit zwei Speicherbausteinen RAM1, RAM2 mit jeweils 32K Worten dargestellt. Sogenannte "Low-active"-Signale $\overline{CS1}$ und $\overline{CS2}$ werden hierbei im Pufferbetrieb durch zwei "Pull-up"-Widerstände Rp1, Rp2 in einem Schalterbaustein S auf "High"-Potential gehalten. Der Adreßbus AB wird parallel an beide Speicherbausteine geführt. Pro Speicherbaustein gibt es acht Datenleitungen im Datenbus DB, die jeweils die acht höherwertigen sowie die acht niederwertigen Bits eines Datenwortes darstellen. Beim ersten Speicherbaustein RAM1 ist auf dem Datenbus DB "High"-, und beim zweiten Speicherbaustein RAM2 ist auf dem Datenbus DB "Low"-Potential.

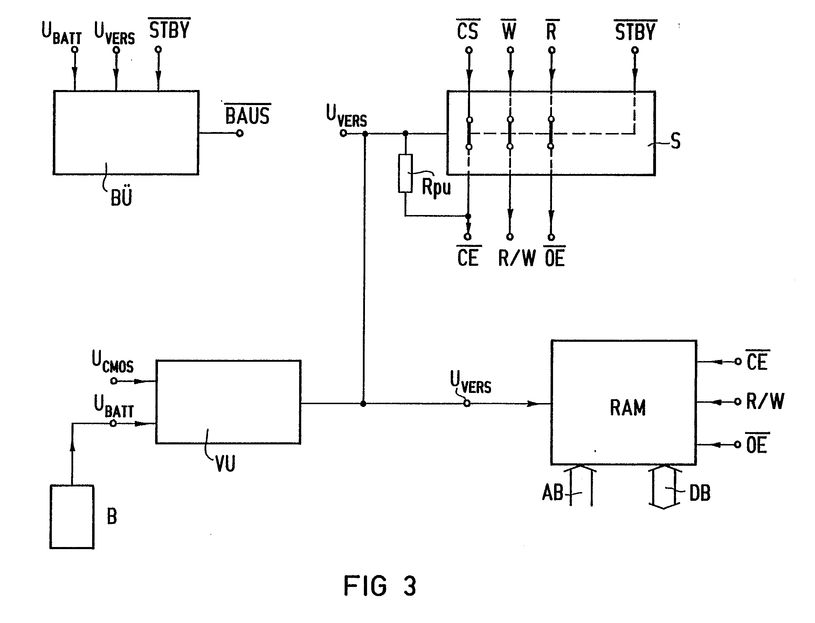

In Figur 3 ist ein Blockschaltbild eines Ausführungsbeispiels der Lösung durch die vorliegende Erfindung dargestellt. Es ist hier eine Überwachungselektronik BÜ für die Modulbatterie mit den Eingangsgrößen $U_{BATT}$, $U_{VERS}$ und dem "Stand by"-Signal $\overline{STBY}$ und der Ausgangsgröße $\overline{BAUS}$ sowie eine Abwandlung des gemäß der Figur 1 dargestellten Schalterbausteins S vorhanden. Die Spannung $U_{BATT}$ einer Batterie B kann über eine Versorgungsumschaltung VU auf den Speicherbaustein RAM geschaltet werden. Das Schreib-und das Lesesignal $\overline{W}$ und $\overline{R}$ können hier auch direkt an die Speicherbausteine angeschlossen werden, wenn die Signale R/W und $\overline{OE}$ intern mit dem Signal $\overline{CE}$ verknüpft werden.

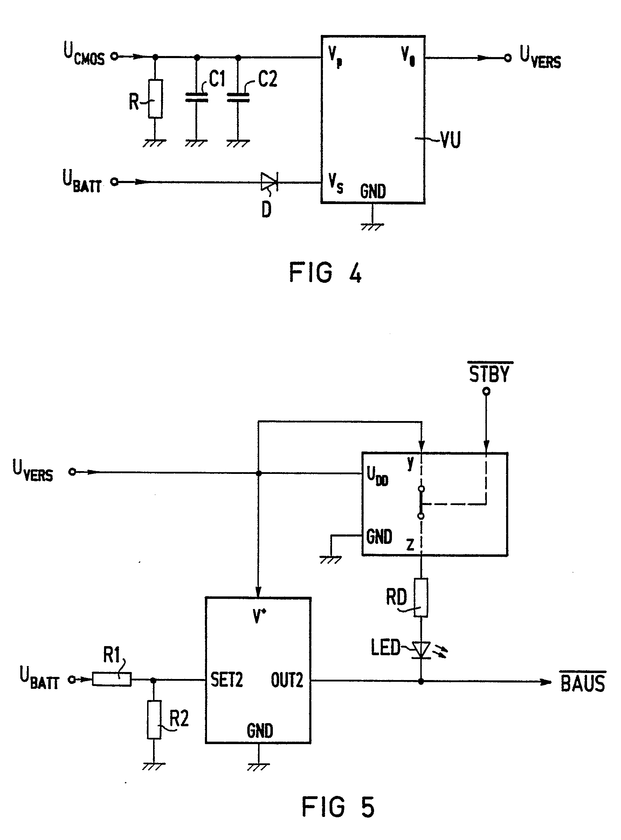

Figur 4 und Figur 5 zeigen jeweils eine Realisierung der Versorgungsumschaltung VU und der Überwachungselektronik BÜ mit Hilfe von zwei integrierten Schaltkreisen. Ein Baustein der Versorgungsumschaltung VU (beispielsweise ICL 7673) schaltet den höheren Spannungswert zwischen den Eingängen $V_P$ und $V_S$ auf $V_O$ durch. Eine Diode D sorgt dafür, daß im Pufferbetrieb, wenn das Modul angeschlossen ist, für den kleinsten Wert der Spannung $U_{CMOS}$ $V_S$ immer noch kleiner ist als $V_P$. Wenn in einem elektronischen System die Batteriepufferung von statischen CMOS-Speicherbausteinen überwacht werden soll, d. h. die Unterschreitung eines Schwellwertes durch die Batteriespannung erkannt und eventuell angezeigt werden soll, muß der Strombedarf der Überwachungselektronik gegenüber dem Strombedarf der CMOS-Speicherbausteine (typisch 2 µA/Baustein) kleiner oder von derselben Größenordnung sein, so daß der gesamte Strombedarf die Pufferungsdauer der Batterie nicht erheblich einschränkt. In einem Baustein (beispielsweise ICL 7665) ist ein Schalter (OUT2) eingebaut, der anspricht, wenn das Eingangssignal (SET2) eine interne Spannungsreferenz unterschreitet.

Durch Widerstände R1 und R2 gemäß Figur 5 wird ein Schwellwert für die Spannung der Batterie $U_{BATT}$ eingestellt. Unterschreitet die Batteriespannung den eingestellten Schwellwert, dann spricht das Signal $\overline{BAUS}$ an. Wenn die Hauptversorgung aktiv ist, dann wird der Stromkreis für eine lichtemittierende Diode LED über das Signal $\overline{STBY}$ geschlossen und die lichtemittierende Diode LED zur Anzeige gebracht. Das Signal $\overline{STBY}$ könnte weiterhin ins System überführt werden, um es z. B. mit dem entsprechenden Signal für die Systembatterie zu verknüpfen.

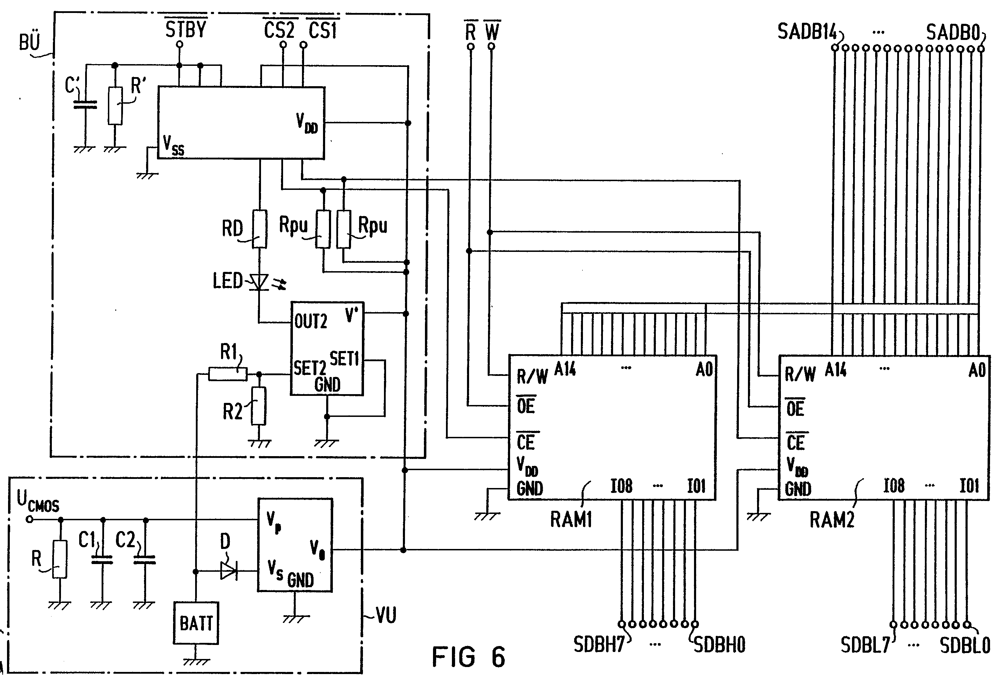

Beim Übersichtsschaltbild nach der Figur 6 sind die schon vorher erläuterten Schaltungen der Versorgungsumschaltung VU und der Überwachungselektronik BÜ mit ihren Schaltungsverbindungen zu den Speicherbausteinen RAM1 und RAM2 dargestellt. Die Speicherbausteine RAM1 und RAM2 sind hier mit Eingangssignalen SDBH0 ... SDBH7 sowie SDBL0 ... SDBL7 an jeweiligen Eingängen I1 ... I8 versehen. Die jeweiligen Ausgänge A0 ... A14 sind jeweils parallelgeschaltet und stellen die Ausgangssignale SADB0 ... SADB14 dar. Als Speicherbausteine können hier die integrierten Schaltungen TC 55257 PL verwendet werden.

## Ansprüche

1. Stromversorgung für Speicherbausteine,
-welche auch in einem von der regulären Stromversorgung getrennten Zustand mit einem für die Erhaltung der gespeicherten Daten notwendigen Strom versorgt werden,
**dadurch gekennzeichnet, daß**
-mit dem Speicherbaustein (RAM; RAM1, RAM2) eine Modulbatterie (B) fest verbunden ist, die bei einem Entfernen des Speicherbausteins (RAM; RAM1, RAM2) aus einer elektronischen Schaltung stoßfrei die Stromversorgung übernimmt, und daß -eine Überwachungselektronik (BÜ) vorhanden ist, die ebenfalls mit dem Speicherbaustein (RAM; RAM1, RAM2) fest verbunden ist und das Unterschreiten eines Schwellwertes für die Spannung der Modulbatterie (B) überwacht und anzeigt.

.2. Stromversorgung für Speicherbausteine nach Anspruch 1, **dadurch gekennzeichnet, daß** -die Überwachungselektronik (BÜ) nur beim Vorhandensein der regulären Stromversorgung aktiv ist.

86 P 4436 E

$\overline{CS}$  $\overline{W}$  $\overline{R}$  $\overline{STBY}$

AB

RAM

DB

$U_{CMOS}$

## FIG 1

$\overline{CS1}$  $\overline{CS2}$  $\overline{STBY}$

$U_{CMOS}$

Rp1  Rp2

S

$\overline{CE1}$  $\overline{CE2}$

$U_{CMOS}$  AB  15

$\overline{CE1}$

R/W=$\overline{W}$

SRAM  $\overline{OE}=\overline{R}$

RAM1

8  DB

$U_{CMOS}$  AB  15  RAM2

$\overline{CE2}$

R/W=$\overline{W}$

SRAM  $\overline{OE}=\overline{R}$

8  DB

## FIG 2

FIG 3

FIG 4

FIG 5

86 P 4436 E

FIG 6

SADB0 ... SADB14

SADB0

A0 ... A14
R/W  $\overline{OE}$  $\overline{CE}$  $V_{DD}$  GND
I01 ... I08
RAM2
SDBL0 ... SDBL7

A0 ... A14
R/W  $\overline{OE}$  $\overline{CE}$  $V_{DD}$  GND
I01 ... I08
RAM1
SDBH0 ... SDBH7

$\overline{R}$  $\overline{W}$
$\overline{R}$  W

BÜ

$\overline{CS2}$  $\overline{CS1}$
$\overline{STBY}$
$V_{DD}$
$V_{SS}$
C'  R'
Rpu
Rpu
RD
LED
OUT2  V'
SET2  SET1  GND
R1  R2

VU
$V_P$  $V_0$
$V_S$  GND
D
BATT
$U_{CMOS}$
C1  C2
R

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | ELEKTRONIK, Band 35, Nr. 9, Mai 1986, Seiten 66-72, München, DE; N. MÜLLER et al.: "Lithium-Power-Module: Speicherinhalte am Leben erhalten" * Figuren 1,3,5; Seite 66, linke Spalte, Zeile 1 - Seite 68, rechte Spalte, Zeile 27 * --- | 1,2 | G 11 C 5/00 |
| Y | GB-A-2 084 769 (RACAL MICROELECTRONIC SYSTEMS LTD) * Figuren 1,4; Seite 1, Zeilen 39-64; Seite 2, Zeilen 3-78 * --- | 1,2 | |
| Y | US-A-4 399 524 (MUGURUMA et al.) * Spalte 1, Zeilen 50-61; Spalte 3, Zeilen 19-35; Figur 2 * --- | 1,2 | |
| A | EP-A-0 111 153 (TOKYO SHIBAURA DENKI K.K.) * Seite 5, Zeile 22 - Seite 6, Zeile 7; Figur 2 * ----- | 1 | |

RECHERCHIERTE SACHGEBIETE (Int. Cl.4)

G 11 C

Der vorliegende Recherchenbericht wurde für alle Patentansprüche erstellt

| Recherchenort | Abschlußdatum der Recherche | Prüfer |
|---|---|---|
| DEN HAAG | 19-11-1987 | CLEARY F.M. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)